# EUROPEAN PATENT APPLICATION

(11) **EP 4 203 205 A1**
(43) Date of publication of application: **28.06.2023**
(21) Application number: 21216774.6
(22) Date of filing: 22.12.2021
(51) Int. Cl.: H01S 3/04, H01S 3/06, H01S 5/024, H01S 5/183, H01S 3/042, H01S 3/094, H01S 5/04

(54) **A LASER AMPLIFICATION MODULE FOR A SOLID-STATE LASER SYSTEM AND A METHOD FOR MANUFACTURING THEREOF**

(71) Applicant: Fyzikální ústav AV CR, v. v. i., 18221 Praha 8 (CZ); Innotonix GmbH, 1010 Vienna (AT)
(72) Inventor: SEZER, Ugur, Vienna, 1010 (AT); Smrz, Martin, 25241 Dolni Brezany (CZ); Cvrcek, Jan, 25241 Dolni Brezany (CZ); Novak, Ondrej, 25241 Dolni Brezany (CZ)
(74) Representative: Bauer, Karel

(57) **Abstract**

The present invention relates to a laser amplification module for a solid-state laser. More particularly, the present invention relates to the module amplifying laser beam capable to provide effective cooling of a heat sink bonded to a solid-state disk. The monolithic laser amplification module (1) comprises a solid-state disk (2); a monolithic composite (6) comprising a heat sink (3) and a reflecting coating (4) configured to at least partially reflect an incident beam (5) propagated in the solid-state disk (2) in a wavelength range λ from 200 nm - 10 µm, wherein the reflecting coating (4) is deposited on surface of the heat sink by a deposition method, wherein the heat sink (3) has: transverse thermal conductivity at least 100 W/m*K, Young's modulus at least 100 GPa, preferably at least 300 GPa; and thickness of the heat sink at least 1 mm, preferably at least 2 mm; and wherein the solid-state disk and the monolithic composite have surfaces (61 and 21) having PV-flatness < 210 nm and have a surface roughness RMS < 2 nm; and wherein the surfaces (21 and 61) of the solid-state disk (2) and the monolithic composite (6) are directly and permanently bonded together.

## Description

### Technical field

The present invention relates to a laser amplification module for a solid-state laser. More particularly, the present invention relates to the module amplifying laser beam capable to provide effective cooling of a heat sink bonded to a solid-state disk.

In a further aspect, the present invention relates to a method of manufacturing thereof.

### Background art

High-average-power laser systems are suffering from the heat generated in laser components, in particular during the beam amplification. Usually, a solid-state laser disk is glued or soldered on a water-cooled heat sink, wherein the heat is transferred from the solid-state laser disk to the heat sink. This technique of heat removal is not very efficient and has resulted in a poor beam pointing in most high-average-power laser systems especially when the average power approaches the kW-class regime.

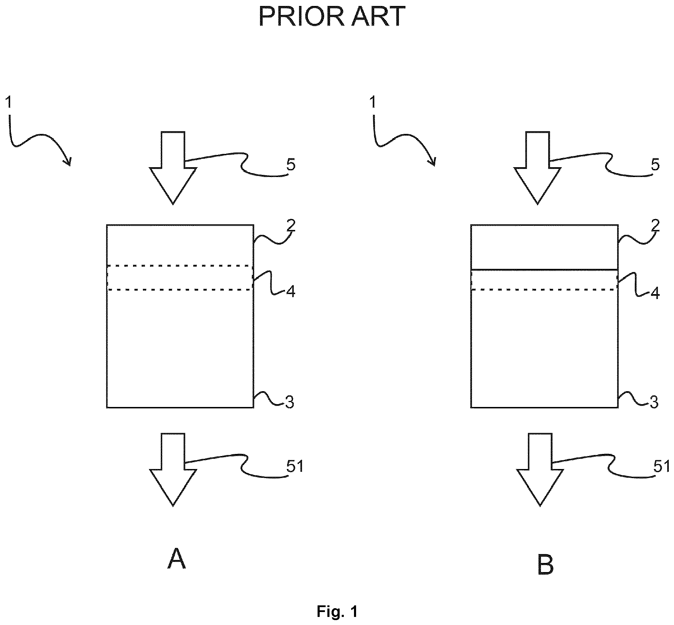

EP 2 996 211 A1 discloses a solid-state laser active medium, also known as a solid-state disk, directly bonded to a transparent heat sink. The heat sink has thermal conductivity greater than or equal to 149 W/m*K; wherein the solid-state laser active medium and the heat sink exhibit a root-mean square, RMS, surface roughness of <1 nm wherein the optical gain material is attached to the transparent heat sink by direct bonding. The document also discloses a monolithic semiconductor or amorphous structure comprising the solid-state laser disk and a reflective layer on top of the disk. The high-reflectivity layer can be attached to the solid-state laser disk by direct deposition method, such as sputtering, evaporation, chemical vapour deposition, etc. or it can be directly bonded to the solid-state disk. Fig. 1 schematically shows two embodiments disclosed in the above-mentioned prior art. The first embodiment, Fig. 1A discloses a module for solid-state laser beam comprising a solid-state disk **2** directly bonded (represented by dashed line) to a reflective layer **4** and directly bonded to a transparent heat sink **3.** An optical beam **5** is incident on solid-state disk **2** and propagates through the reflective layer **4** and the transparent heat sink **3.** The amplified beam **51** is ejected from the transparent heat sink **3.** The second embodiment, Fig. 1B schematically shows a module for solid-state laser beam comprising a solid-state disk **2** and a reflective layer **4** deposited on the solid-state disk **2** (represented by full line) which is directly bonded (represented by dashed line) to a transparent heat sink **3.** An optical beam **5** is incident on solid-state disk **2** and propagates through the reflective layer **4** and the transparent heat sink **3.** The amplified beam **51** is ejected from the transparent heat sink **3.** Both embodiments, however, are disadvantageous in case of heat removal by water jet coming from the bottom of the heat sink **2.**

Therefore, it is an object of the present invention to provide a laser amplification module for a solid-state laser system capable to remove heat therefrom effectively, while the manufacturing thereof is easier compared to the prior art embodiments. Removing the heat more effectively will inevitably result in higher and more stable laser performances. The surface activation ensures bond strengths of at least 0,5 J/m² at temperatures <500°C. Both surfaces are then aligned with respect to each other and bonded in ambient pressure or in vacuum and to provide easier manufacturing.

### Summary of the Invention

The first aspect of the present invention, a monolithic laser amplification module for a solid-state laser system, providing the solution to the above-mentioned objective is defined by claim 1.

The laser amplification module according to the present invention can be implemented into a solid-state laser system for emitting a laser beam, in particular a high-power laser beam for industrial or scientific use such as laser drilling, laser shock peening, particle acceleration, etc.

The solid-state laser is a species of laser using a gain medium being solid. In accordance with the present invention, the solid medium is a solid-state disk, also known in the state of the art as a thin-disk laser, which is a species of diode pumped solid-state laser characterized by a heat sink and laser output that are realized on opposite side of a thin layer of active gain medium. The laser disk can be of any shape, preferably circular or rectangular. The thickness of the solid-state disk is considerably smaller than the laser beam diameter. Within the context of this invention, the term gain medium should be understood as a material capable of generating optical gain, wherein it is understood that optical gain describes the optical amplification process in the material. The gain medium can be both, doped or undoped crystal for example, YAG, sapphire, silicate, garnets, vanadates, tungstates, or phosphate glasses, preferably doped with laser-active ions, ceramic materials or semiconductor material such as GaAs, InGaAs or GaN. Dopant content can be varied depending of particular use of the solid-state laser system, preferably from 0.01 - 20 molar (atomic) %. In another embodiment, the solid-state disk may be from an amorphous gain material such as phosphate glasses or amorphous silica etc. The solid-state disk can have any thickness, however, it is advantageously provided that the module, resp. method, according to the present invention is capable to provide thicknesses as low as 5 µm.

Monolithic composite shall be understood as a continuous solid element comprising a heat sink and a reflective coating. The reflective coating shall be deposited on the heat sink by state-of the art deposition methods such as physical vapor deposition, sputtering, evaporation, chemical vapor deposition, or even crystal growth techniques such as molecular beam epitaxy. The reflective coating is configured to at least partially reflect an incident beam, particularly a pump beam. The reflective coating reflects the beam having the wavelength from the range from 200 nm to 10 µm. The reflective coating can be selected from a group of materials: zinc sulfide, titanium dioxide, tantalum pentoxide, silicon dioxide, hafnium oxide, gallium arsenide, alluminium gallium arsenide etc.

The heat sink according to the present invention has transverse thermal conductivity at least 100 W/m*K, Young's modulus at least 100 GPa; and thickness of the heat sink at least 1 mm. The heat sink can be made from diamond, boron nitride, silicon, silicon carbide (SiC), ceramic, metal, metal-diamond composite, metal-boron nitride composite or silicon-diamond composite. In a more preferred embodiment, the Young's modulus of the heat sink is at least 300 GPa and/or thickness thereof is at least 2 mm. The thickness of the heat sink at least 2 mm prevent bending during the coating process.

The monolithic composite and the solid-state disk have surfaces, both having PV-flatness < 210 nm and roughness RMS < 2 nm. The above-mentioned surfaces are directly and permanently bonded together. A direct bonding process should be understood as joining of the laser disk directly to the heat sink without any intermediate adhesive layers, such as glues or metallic solders. A heat sink may be understood as a heat spreader or a final carrier substrate with a thermal conductivity greater than or equal to 100 W/m*K at room temperature.

PV (peak to valley) flatness is defined as the absolute difference between the highest and lowest points on an optical surface relative to the ideal surface. RMS is a well-known parameter in the state of the art, which is generally defined as the root mean square of the surface waviness in the nanometer-scale. PV flatness and RMS can be measured by the state of the art methods such as laser interferometers or atomic force microscopes.

The monolithic laser amplification module for a solid-state laser system as defined in claim 1 provides a thermal conductivity of >0.1 W/(m K), preferably >1 W/(m K), for solid-state disk temperatures < 500°C caused by laser operation.

In a preferred embodiment, the monolithic composite comprises at least two layers forming the reflective coating. More preferably, the monolithic composite comprises plurality of layers. The particular number of the layers depends on the industrial application. The skilled person in the particular filed of the solid-state laser knows how many layers is sufficient to meet the desired mirror specifications. For a SiO₂/Ta₂O₅ based coating calculated for 1030 nm at 0° incident angle the reflectivity can vary from 60% for total 4 layer (2 x SiO₂+Ta₂O₅) over 90% for total 8 layers to 99,9% for total 20 layers. The layers forming the reflective coating alternate with respect to the refractive index. The first layer and the second layer have different refractive indices. In an embodiment comprising plurality of layers, the first layer, and the second layer have alternating refractive indices, such as the first layer has n=1,46 (SiO₂); the second layer has n=2,1 (Ta₂O₅) and the third layer has again n=1,46. The final top layer is directly and permanently bonded to the solid-state disk. In a preferred embodiment, the lowest refractive index n_{low} = 1,35 and the highest refractive index n_{high} = 5,6 can be used to manufacture high reflectivity coatings.

The monolithic composite preferably comprises a sacrificial layer. The functional role of this sacrificial layer is (a) for protection of the reflective coating (b) for improving the laser-induced damage threshold and/or (c) to provide a buffer layer that can be post-processed to reach the required surface specifications. The sacrificial layer is made of a material decreasing the reflectivity of the reflective coating less than 10 %. Such a protective sacrificial layer can be SiO₂, Si₃N₄, HfO₂, any oxides of any metals, particularly Al₂O₃, GaAs, AIGaAs, NiP or photoresist material, which can be polished to reach the required surface topography, in particular PV-flatness less than 210 nm and RMS surface roughness RMS<2 nm, preferably PV<70 nm and RMS<0.8 nm. The reflectivity from 90% up to 99.9% is particularly advantageous. At least one sacrificial layer, e.g. made from SiO₂, having thickness 407 nm can increase the LIDT of the underlying multilayered reflecting coating by a factor of about 7.

Even more preferably, the monolithic composite comprises a plurality of sacrificial layers forming a film stack. The plurality of sacrificial layer can be configured to increase the laser-induced damage threshold of the monolithic laser amplification module. The film stack of the sacrificial layer is particularly advantageous in combination with coating comprising AIGaAs or GaAs. These materials exhibit low damage thresholds for pulsed lasers having a length pulse less than 10 ns. More preferably, in a film stack, at least one layer is micro- or nano-structured by a pattern. The pattern increases mechanical and/or thermal properties of the solid-state disk. The pattern can be any kind of the pattern which fits together with the pattern on the opposite surface, which can be the surface of the reflecting coating or a further sacrificial layer or sacrificial layer and the heat sink and/or any combination thereof. The pattern can be in a form of grooves.

In another embodiment, LIDT of multilayered reflecting coating can be increased by manufacturing of nanolaminates that are co-evaporated at the interfaces.

The monolithic composite is preferably polished. The polished surfaces of the monolithic composite and the solid-state disk directly and permanently bonded to each other have flatness PV< 210 nm. The method of polishing can be chosen according to the state of the art, such as mechanical, magnetorheological, chemical or ion-assisted, provided the above-mentioned parameters flatness of PV and RMS are achieved.

Surface of the monolithic composite is preferably curved. Even more preferably, the surface of the monolithic composite is curved, wherein the surface having the PV<210 nm value and RMS < 2 nm are provided in an area larger than 80% of the total surface.

The surface of the solid-state disk and the monolithic composite have PV < 70 nm and RMS < 0.8 nm. These values provide higher bonding strengths.

The heat sink is preferably transparent for wavelengths between 200 nm - 10 µm with an attenuation coefficient < 1 cm⁻¹. The transparent heat sink can provide an embodiment, wherein the output coupling of the laser beam can be provided through the transparent heat sink. In another embodiment, the heat sink can be opaque to the laser wavelength(s) so that, the reflective output coupling of the laser beam can be provided.

The heat sink preferably comprises materials having thermal conductivity at least 100 W/(m*K), preferably diamond, boron nitride, silicon, silicon carbide, ceramic, metal, metal-diamond composite, metal-boron nitride composite or silicon-diamond composite.

The solid-state disk preferably comprises an anti-reflective coating on the surface opposite to the surface directly and permanently bonded to the monolithic composite.

The side edges of the monolithic laser amplification module are preferably roughened and/or bevelled. The roughened and/or bevelled edges minimize amplified spontaneous emission (ASE) from the laser active media.

A second aspect of the present invention is a method of manufacturing of the laser amplification module as defined in claim 15.

The method comprises step of providing a solid-state disk, wherein at least one surface thereof has root mean square RMS of <2 nm and a surface flatness of PV< 210 nm; and wherein thickness thereof is at least 5 µm;

Subsequent step is to provide a heat sink, wherein at least one surface thereof has root mean square RMS of <2 nm and a surface flatness of PV< 210 nm; and wherein thickness thereof is at least 1 mm.

Subsequently, the heat sink is coated by a reflective coating at least partially reflecting an incident beam in a wavelength range A from 200 nm - 10 µm, thereby forming a monolithic composite.

In the final step, aligning and directly bonding the surfaces having RMS of < 2 nm and a surface flatness of PV < 210 nm of both, the monolithic composite and the heat sink, together, is provided.

The step of coating the heat sink by the reflecting coating preferably comprises plurality of coating steps creating a film stack of alternating materials with alternating refractive indices to form an interference coating for reflectivity higher than 90%. The plurality of coating steps can be provided via conventional means such as evaporative, ion assisted, ion beam sputtered or magnetron sputtered or molecular beam epitaxy.

The step of coating may introduce an undesired curvature to the heat sink and possess a high surface roughness RMS>1nm. To compensate the introduced curvature, a skilled person can further provide the step of a) providing the heat sink preferably having Young's modulus at least 300 GPa and thickness at least 2 mm so that a coating-induced bending is very unlikely or b) the high-reflectivity coating can be preferably further provided with a sacrificial layer on top of the reflective coating. Chemical mechanical polishing or ion-assisted polishing processes may help to reduce the void density and at the same time to increase surface quality (PV flatness, RMS surface roughness). It is generally understood that voids are empty spaces (holes) that are caused by outgassing of materials for instance. Defects are considered as errors in the crystal structure.

The method of manufacturing preferably comprises the step of providing a sacrificial layer on top of the reflective coating and polishing thereof to the PV< 210 nm and RMS < 1 nm. The polishing of the protective sacrificial layer can be done by ion beam assisted polishing technique. In this method, typically Argon ions are generated in an ion gun and accelerated towards the protective sacrificial layer. The bombardment of the protective sacrificial layer leads to sputtering of the surface atoms. One can observe a decrease of the surface roughness. The specific substrate material, the angle of incidence as well as the ion beam voltage have big impacts on the end-quality of the surface roughness. With this processing method it is also possible to accurately change the surface topography, especially etching the substrate to a very high degree of flatness (PV < 10 nm for fused silica substrates). To avoid surface voids during processing, the surface is kept very clean and soft beam parameters (low ion energy) are chosen accordingly.

In another embodiment of providing a sacrificial layer on top of the reflective coating and polishing thereof is a chemical mechanical polishing. The chemical mechanical polishing process is a common procedure in the semiconductor industry applied to various wafer materials. It is a combination of chemical etching for atomic scale material removal and mechanical wearing for overall flatness attainment. The resulted surface can achieve a flatness of PV < 70 nm and a surface roughness RMS < 0.5 nm depending on the material.

The step of direct bonding comprises providing a monolithic composite as well as the solid-state disk being excessively cleaned and surface activated. The surface activation can be a chemical, plasma or ion-beam activation. The surfaces are subsequently pressed together. The applied pressure may vary depending on the thickness of the substrates but typically ranges between 2 kPa to 10 MPa. For curved substrates the alignment with a precision of <5 µm serves for high bond strengths.

The method according to the present invention can provide bond strength from 0.1 J/m², advantageously 0.5 J/m². This allows the mechanical polishing of the second surface of the solid-state disk and/or thinning it to the desired thickness, which is typically > 5 µm, ideally > 100 µm. After thinning and/or polishing, the second surface of the solid-state disk exhibits a high flatness (ideally < 70 nm) and a low RMS surface roughness (ideally RMS< 0.8 nm).

The method can preferably comprise the step of coating the surface configured to receive the optical beam from a pump source. This surface can then be coated with an antireflection coating for efficient laser operation. The coating can be carried out by conventional means such as evaporative, ion assisted, ion beam sputtering or magnetron sputtering. Alternatively, one may also use semiconductor-based antireflection coating (AIGaAs/GaAs).

In a further preferred embodiment, the method further comprises side-roughening of the bonded disk and/or bevelling. The side-roughening and/or bevelling minimize amplified spontaneous emission (ASE) from the laser gain media when the edges are roughened. The higher surface roughness creates small reflection sites causing large diffraction losses to the reflected light. Another approach to suppress ASE is to bevel the edges of the thin-disks.

### Brief Description of the Drawings

**Fig. 1A** and **1B** represent two embodiments according to the state of the art.
**Fig. 2** represents a first embodiment according to the present invention.
**Fig. 3** represents a preferred embodiment comprising two layers forming the reflecting coating.
**Fig. 4** represents a preferred embodiment comprising a plurality of alternating layers forming the reflecting coating.
**Fig. 5** represents a preferred embodiment comprising a sacrificial layer on top of the coating.
**Fig. 6** represents a preferred embodiment comprising a nanostructured sacrificial layer.
**Fig. 7** represents a preferred embodiment comprising an anti-reflective coating.
**Fig. 8A** and **8B** represent preferred embodiments depicting the module according to the present invention.
**Fig. 9** represents an implementation of the laser amplification module according to the present invention in a solid-state laser system.
**Fig. 10A** and **10B** show experimental examples according to the present invention with varying thicknesses of the sacrificial layer on top of the reflective coating.
**Fig. 11A** shows a comparative study - the example according to the present invention.
**Fig. 11B** shows a comparative study - another example according to the present invention.
**Fig. 12** shows a comparative study - the example according to the state of the art.

### Detailed description

Compared to the state-of-the art, the reflective coating forming a high-performance reflector (>98%) are deposited on the solid-state disk by a deposition method, in particular sputtering. This introduces an intrinsic film stress inside the coating leading to an excessive solid-state disk curvature. The thinner and elastic the solid-state disk is, the more it is bent. However, in accordance with the present invention, a heat sink having Young's modulus at least 100 GPa and a thickness of > 1mm ensures that the heat sink is mechanically rigid so that the bending is not that profound and the PV flatness can still be used or corrected for the direct bonding with the solid-state disk.

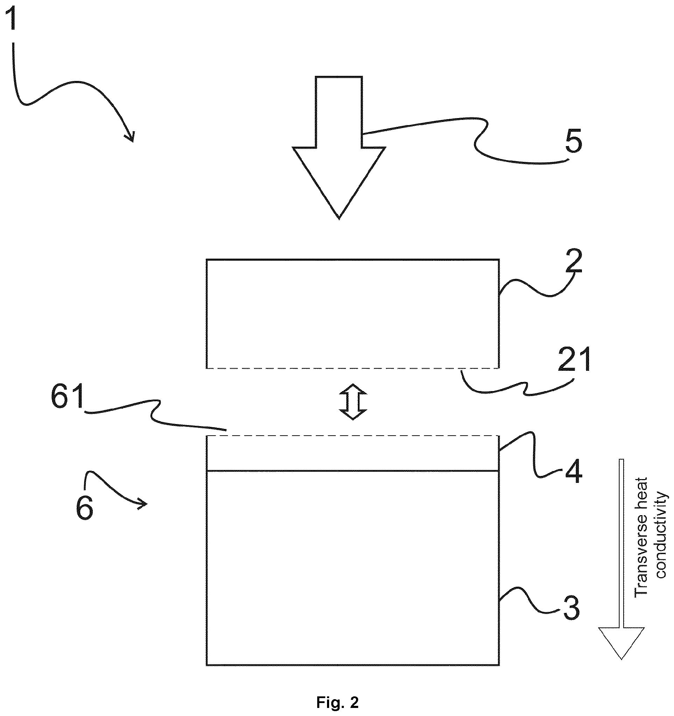

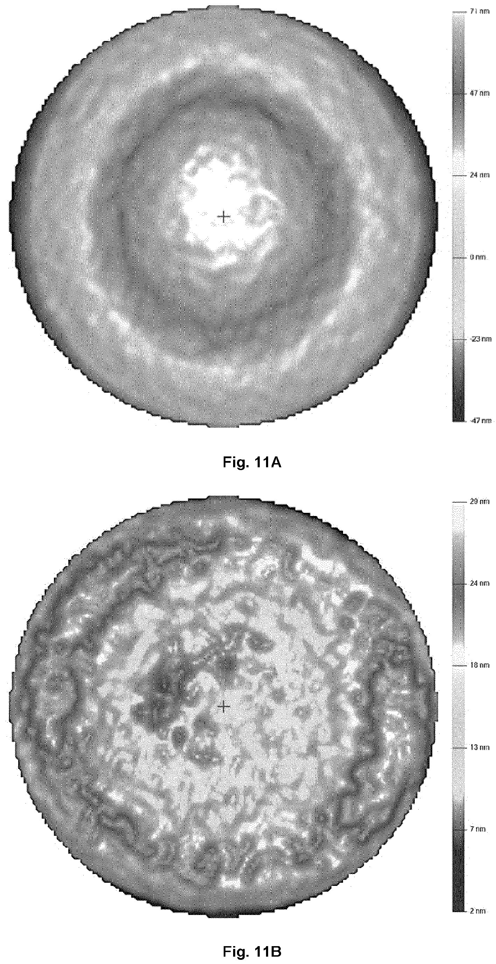

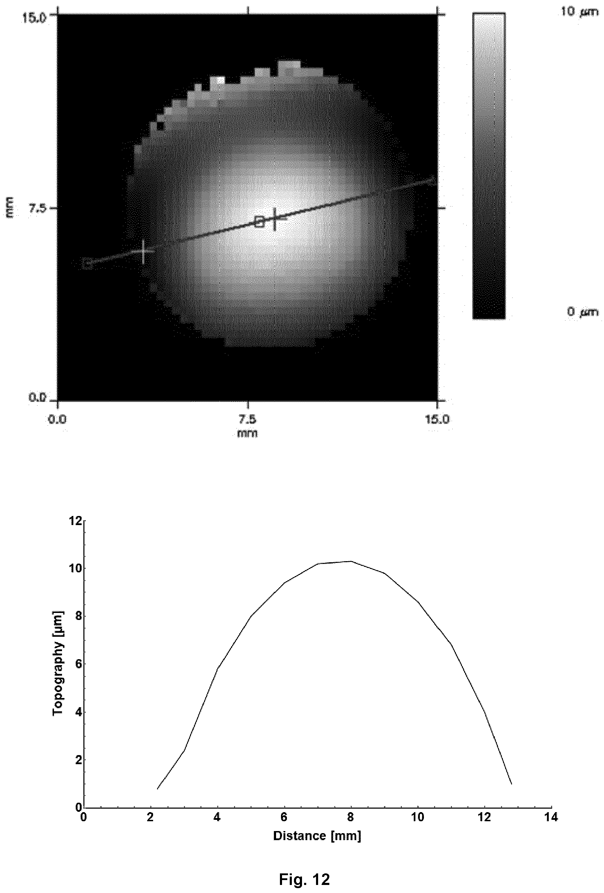

**Fig. 2** schematically shows a first embodiment according to the present invention. A monolithic laser amplification module **1** for a solid-state laser system is shown. The module **1** comprises a thin solid-state disk **2** made from optical gain medium, such as doped or undoped crystal for example, YAG, sapphire, silicate, garnets, vanadates, tungstates, or phosphate glasses, preferably doped with laser-active ions, ceramic materials or semiconductor material such as GaAs, InGaAs or GaN. In general, a skilled person in the art of laser designing knows which species of the gain medium is suitable for particular industrial application. The solid-state disk **2** has two surfaces. The first surface serves as a plane for an incident beam **5,** such as a pump beam from a pumping source of the solid-state disk laser. The pump beam can be another laser beam. The opposite surface **21** is treated so that, the PV-flatness < 210 and RMS < 2 nm is achieved. The treatment resulting with these parameters are, for example annealing, polishing, or any of the mechanical- and/or chemical treatment. The surface **21** is configured with the above-mentioned parameters to provide a direct and permanent bond with a monolithic composite **6.** The monolithic composite **6** comprises a heat sink **3** and a reflective coating **4.** The monolithic composite **6** has the surface **61** being treated so that the PV-flatness < 210 nm and RMS < 2 nm. The direct and permanent bonding provides joining of the solid-state disk **2** directly to the monolithic composite **6** without any intermediate adhesive layers, such as glues or metallic solders. This bonding provides strength from 0.1 J/m², preferably > 0.5 J/m². The heat sink **3** has transverse thermal conductivity at least 100 W/m*K, Young's modulus at least 100 GPa, preferably at least 300 GPa, and thickness of the heat sink at least 1 mm, preferably at least 2 mm. The heat sink can be made from diamond, boron nitride, silicon, silicon carbide (SiC), ceramic, metal, metal-diamond composite, metal-boron nitride composite or silicon-diamond composite. The thickness of the heat sink at least 2 mm prevent bending during the coating process, which can be proved by the experiment described in accordance with **Fig. 11A, 11B** and **12****.** The monolithic composite **6** further comprises a reflecting coating **4** deposited on top of the heat sink **3.** The reflective coating **4** can be deposited on the heat sink **3** by state-of the art deposition method such as chemical vapor deposition, sputtering, evaporation, chemical vapor deposition, or even crystal growth techniques such as molecular beam epitaxy. The reflective coating is configured to at least partially reflect an incident beam **5** propagated through the solid-state disk **2,** particularly a pump beam. The reflective coating **4** reflects the beam having the wavelength from the range from 200 nm to 10 µm. The reflective coating can be selected from the group of: zinc sulfide, titanium dioxide, tantalum pentoxide, silicon dioxide, hafnium oxide, gallium arsenide, aluminum gallium arsenide etc. The reflective coating **4** is thus sandwiched between the heat sink **3** and the solid-state disk **2.**

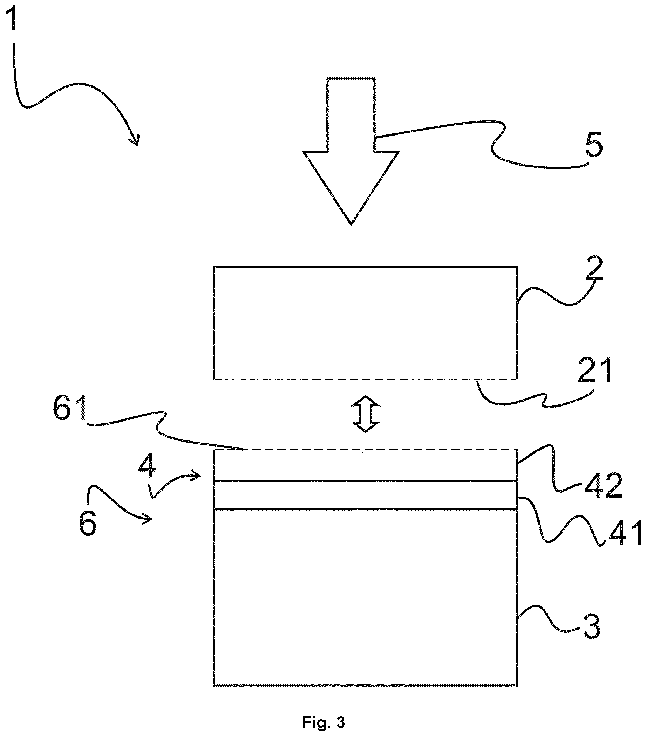

**Fig. 3** further shows a preferred embodiment, wherein the reflective coating **4** comprises at least two layers **41** and **42.** The first layer **41** can be made from Si having a refractive index about 3,97 and the second layer **42** can be made from SiO₂ having the refractive index about 1.46.

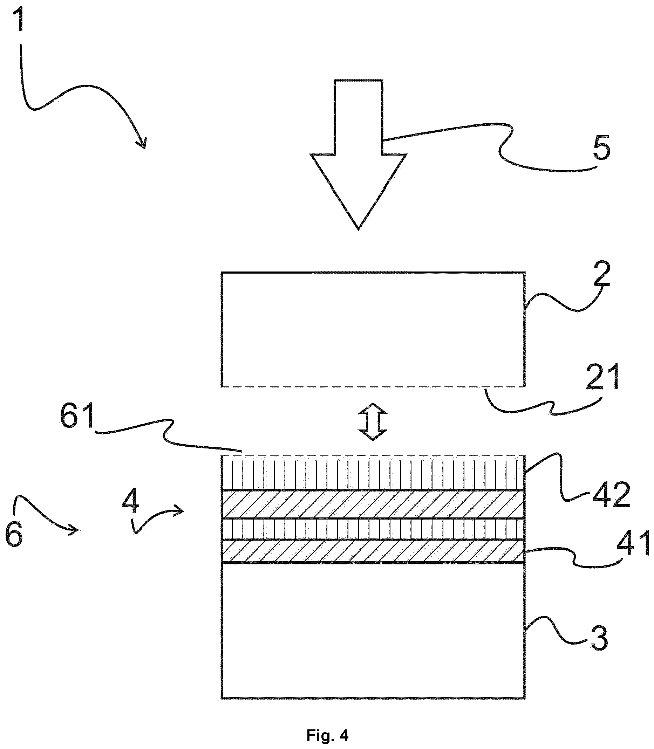

**Fig. 4** further shows another preferred embodiment, wherein the reflective coating **4** comprises a plurality of layers with materials having alternating refractive index. In an embodiment shown in **Fig. 4****,** four reflective layer are chosen. The first layer **41** can have refractive index n=2.1, the second layer can have refractive index n=1.5, the third layer can have refractive index n=2.1 and the top layer **42** can have a refractive index n=1.5. In another preferred embodiment, the set of alternating layers can be adopted from EP3076208.

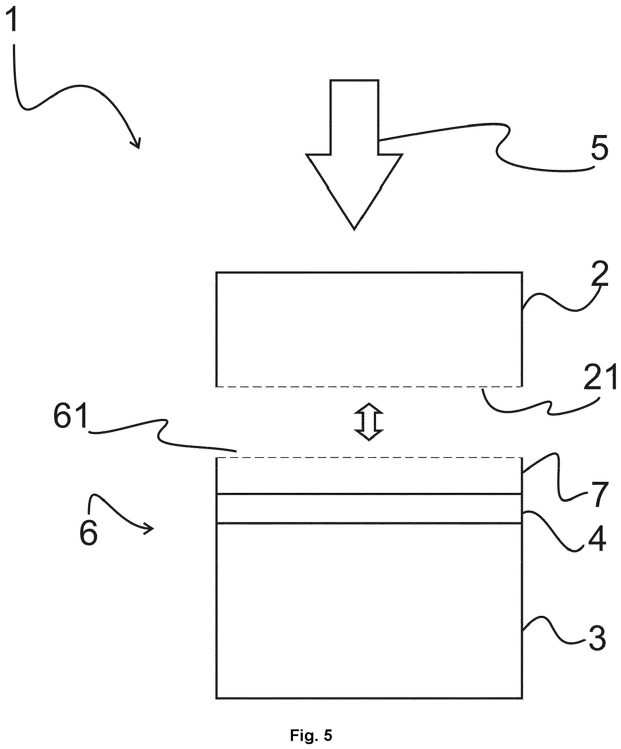

**Fig. 5** further shows another preferred embodiment, wherein the monolithic composite **6** further comprises a sacrificial layer **7** provided on top of the reflective coating and having the surface with the PV-flatness < 210 nm and RMS < 2 nm so that, the direct and permanent bonding with the solid-state disk **2** can be set. The sacrificial layer **7** serves for protection of the reflective coating **4.** The sacrificial layer **7** can be preferably made of material decreasing the reflectivity of the reflective coating less than 10 %. The sacrificial layer **7** can be made of SiO₂, Si₃N₄, HfO₂, any oxides of any metals, particularly Al₂O₃, GaAs, AIGaAs, NiP or photoresist material, which can be polished to reach the required surface topography, in particular PV-flatness less than <210 nm and RMS surface roughness RMS<2 nm, preferably PV<70 nm and RMS<0.8 nm. The reflectivity from 90% up to 99.9% is particularly advantageous. At least one sacrificial layer, e.g. made from SiO₂, having thickness 407 nm can increase the LIDT of the underlying multilayered reflecting coating by a factor of about 7 as shown in experimental result according to Schlitz et al., Applied Optics 56 (4), C136-C139.

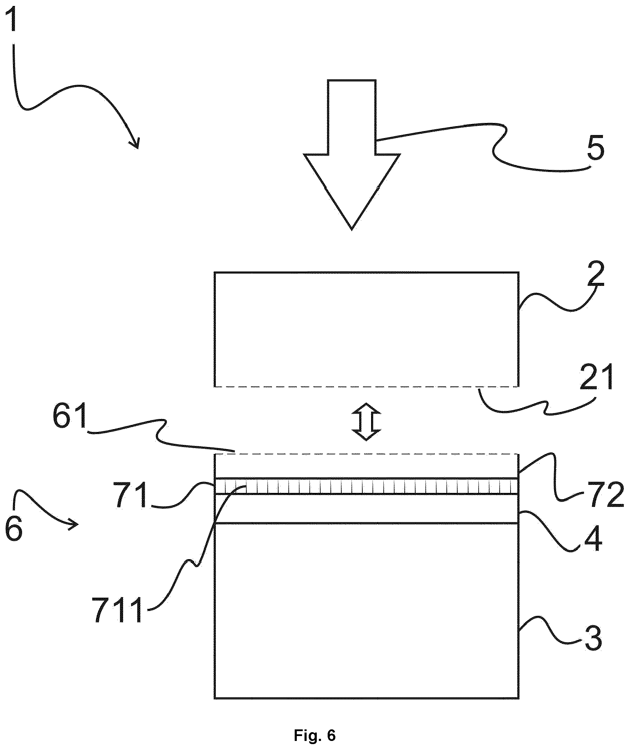

**Fig. 6** comprises a plurality of sacrificial layers **71, 72** for protection of the reflective coating **4** forming a film stack. The plurality of sacrificial layers **71, 72** can be configured to increase the laser-induced damage threshold of the monolithic laser amplification module. More preferably, in a film stack, at least one layer is micro- or nano-structured by a pattern. The pattern increases mechanical and/or thermal properties of the solid-state disk. The pattern can be a grove fitting to each other in order to increase the surface. The increased surface area can provide higher thermal transfer, which provides better laser stability. The particular pattern in terms of shape, size, periodicity can be achieved by the state of the art method such as lithography. The nesting groves may have a rectangular shape, for example. The nano or micro pattern can be provided either on respective surfaces of sacrificial layers, a surface of the reflecting coating which does not serve for direct bonding and the sacrificial layer or on the interface between the coating and the heat sink.

In an embodiment, not depicted in the drawings, the surface **61** of the monolithic composite directly and permanently bonded to the solid-state disk **2** has flatness of PV< 70 nm. Such a flatness of the PV can be achieved by polishing by the state of the art method, such as mechanical, chemical or ion-assisted polishing.

In yet another embodiment, the surface **61** of the monolithic composite **6** directly and permanently bonded to the solid-state disk **2** is curved. The radius of curvature can be >0.05 m, more preferably >0.5 m.

In yet another embodiment, the surface **21** of the solid-state disk **2** and the surface **61** of the monolithic composite **6** have PV < 70 nm and RMS < 0.8 nm.

In yet another embodiment, the surface **61** of the monolithic composite **6** is curved, the flatness PV < 210 nm and RMS < 2 nm are provided on the curved surfaces of the monolithic composite **6** and the solid disk **2,** wherein the curved surfaces are a part of the total surface of the monolithic composite, such as more than 80% of the total surface the monolithic composite. Therefore, it is not needed to provide the direct boding overall interface.

In yet another embodiment, the heat sink (3) is transparent for wavelengths between 200 nm - 10 µm with an attenuation coefficient > 1 cm⁻¹ and/or opaque to the laser wavelength(s).

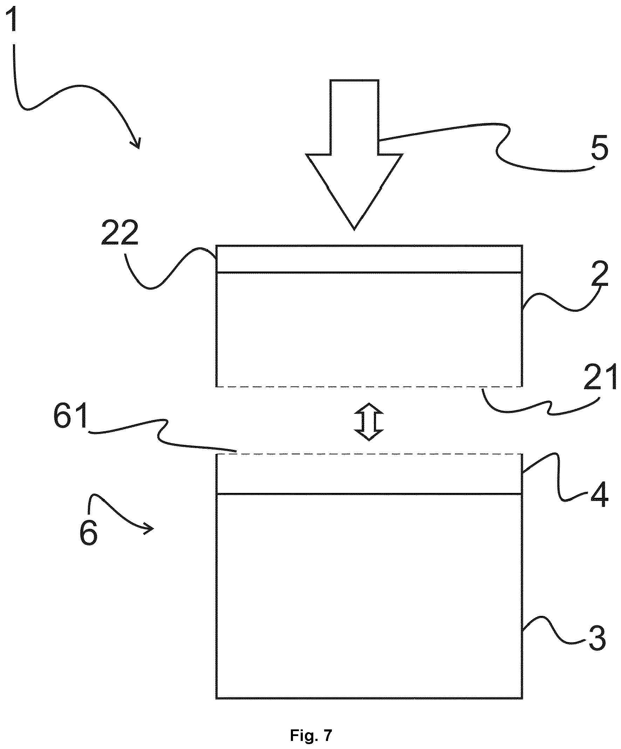

**Fig. 7** shows an embodiment, wherein an antireflective coating **22** is deposited on the surface serving for increasing the transmission and decreasing the amount of unwanted reflected light.

In another embodiment, not shown in the drawings, an edge of the module **1** is roughened and/or bevelled. This embodiment provides minimization of minimize amplified spontaneous emission (ASE) from the laser gain media.

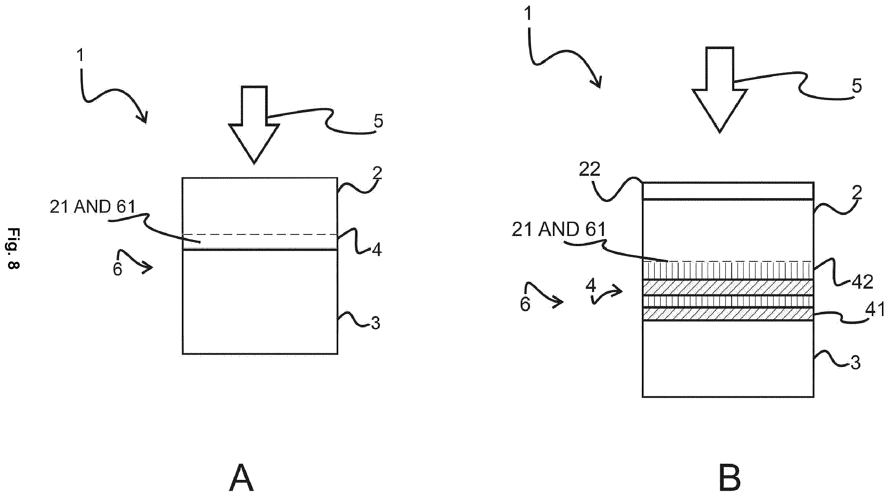

**Fig. 8A** and **8B** show two exemplary embodiments of combination of features according to the present invention.

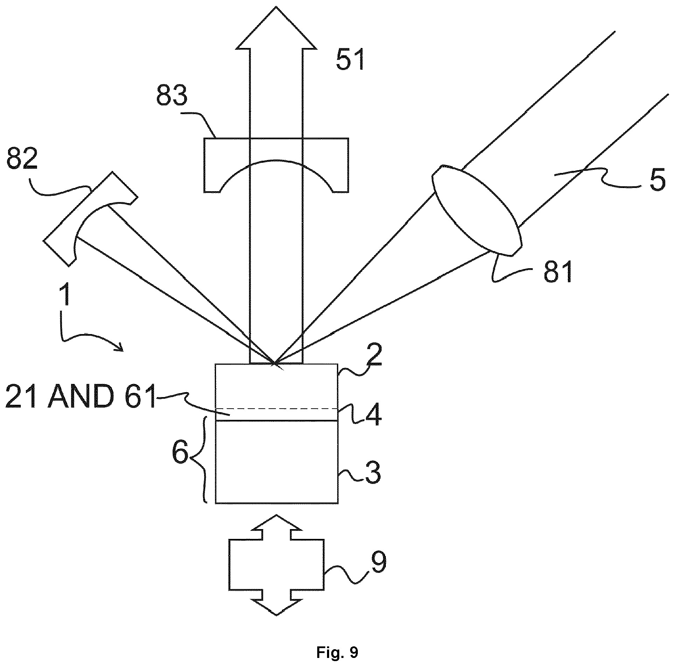

**Fig. 9** shows an exemplary implementation of the module according to the present invention as a part of the disk laser. A pump beam **5** is directed to the module **1** according to the present invention through a lens **81.** A part of the pump beam **5** is absorbed and amplified in the module **1** and part if the beam is reflected to a mirror **82** reflecting the beam back to the module **1.** An amplified laser beam is emitted from the module **1** to a partially reflecting element **83** capable to at least partially reflect the laser beam back to the module **1** and partially transmitting the laser beam **51.**

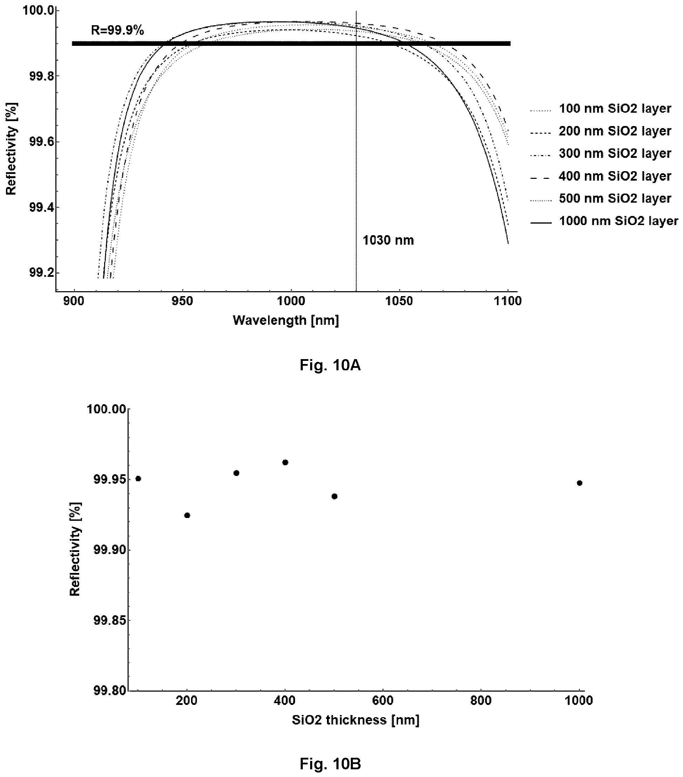

**Fig. 10A** represents a simulation results carried with the module **1.** The simulation shows an example reflectivity of the reflective coating 4 with a sacrificial layer **7** on top of it. Here the reflective coating consists of alternating layers of SiO₂ and Ta₂O₅ with the corresponding refractive indices of 1.46 and 2.1. Here the reflective coating is designed for a central wavelength of 1000 nm leading to a SiO₂ layer thickness of 171,2 nm and a Ta₂O₅ layer thickness of 119 nm. A high reflectivity of 99.9% is achieved through 20 alternating layers. On top of the reflective coating a SiO₂ sacrificial layer is simulated. Fig. 10A shows the different reflectivity behaviours of the coating at different thicknesses of the sacrificial layer.

**Fig. 10B** represents the dependence of the reflectivity of the coating to the thickness of the sacrificial layer thickness. The coating is configured in the same way as for Fig. 10A. It is shown that the thickness of the sacrificial layer only has a marginal effect on the final reflectivity performance of the coating. Based on this fact, the sacrificial layer can be used for improving the surface quality, establishing a PV<210 nm and RMS surface roughness of < 2 nm.

**Fig. 11A** shows an experimental proof of a coated heatsink. In this example the heat sink has a Young's modulus of >300 GPa and a thickness of 2 mm with a diameter of 12 mm. The heat sink is first polished to a flatness of PV< 70 nm and a surface roughness of RMS < 0.4 nm. The flatness measurement is carried out with a laser interferometer operating at 632.8 nm. The surface roughness is measured with an atomic force microscopy in the non-contact mode. A high reflectivity coating of a total thickness of approximately of 4 µm consisting of SiO₂/Ta₂O₅ with a 340 nm SiO₂ sacrificial layer on top is applied onto the heat sink providing a reflectivity of >99.9% for 1030 nm. The coating introduces a spherical curvature. The measured PV flatness is about 130 nm and the surface roughness is measured to be around RMS = 0.5 nm. Comparing the coating-induced bending with state-of the art technology as depicted in Fig. 12, the invention described here provides an almost a factor of 100 less bending. In case the PV flatness of 130 nm is still too high, a sacrificial layer can be co-deposited and subsequently polished to the required surface quality.

**Fig. 11B** shows an experimental proof of a coated heatsink with a polished sacrificial layer. In this example the heat sink has a Young's modulus of >300 GPa and a thickness of 2 mm with a diameter of 12 mm. The heat sink is first polished to a flatness of PV< 70 nm and a surface roughness of RMS < 0.4 nm. The flatness measurement is carried out with a laser interferometer operating at 632.8 nm. The surface roughness is measured with an atomic force microscopy in the non-contact mode. A high reflectivity coating of a total thickness of approximately of 4 µm consisting of SiO₂/Ta₂O₅ with a 340 nm SiO₂ sacrificial layer on top is applied onto the heat sink providing a reflectivity of >99.9% for 1030 nm. The top sacrificial layer is then polished via an ion-beam assisted polishing method. With this method, a surface with a PV flatness of <40 nm and a RMS surface roughness of <0.4 nm can be achieved. Comparing the ion assisted post-polishing method with the sate-of-the art technology as depicted in **Fig. 12****,** the invention described here provides more than a factor of 300 better surface flatness.

On the other hand, **Fig. 12** shows the experimental result according to the state of the art, in particular approach EP 2 996 211 in which a solid-state disk of a thickness of 200 µm is coated. To minimize the curvature, an anti-stress coating was applied here. Nevertheless, one can see that solid-state disk is excessively curved up to PV = 10 µm. This high bending will decrease the bonding strength due to counteracting molecular forces. The topography is measured across the whole diameter of the solid-state disk (blue line)

**Reference signs**

| | |
|---|---|
| 1 | monolithic laser amplification module |
| 2 | solid-state disk |
| 21 | surface of the solid-state disk |
| 22 | antireflective coating |
| 3 | heat sink |
| 4 | reflecting coating |
| 41 | first layer |
| 42 | second layer |
| 5 | incident beam |
| 6 | monolithic composite |
| 61 | surface of the monolithic composite |
| 7 | sacrificial layer |
| 71 | first sacrificial sub-layer |
| 711 | nano or micro pattern on the sacrificial layer |
| 72 | second sacrificial sub-layer |
| 81 | lens |
| 82 | mirror |
| 83 | partially reflecting element |
| 9 | cooling |

## Claims

1. A monolithic laser amplification module (1) for a solid-state laser system comprising
- a solid-state disk (2);
- a monolithic composite (6) comprising a heat sink (3) and a reflecting coating (4) configured to at least partially reflect an incident beam (5) propagated in the solid-state disk (2) in a wavelength range A from 200 nm
- 10 µm, wherein the reflecting coating (4) is deposited on surface of the heat sink by a deposition method, wherein the heat sink (3) has:
- transverse thermal conductivity at least 100 W/m*K,
- Young's modulus at least 100 GPa, preferably at least 300 GPa; and
- thickness of the heat sink at least 1 mm, preferably at least 2 mm; and wherein
- the solid-state disk and the monolithic composite have surfaces (61 and 21) having PV-flatness < 210 nm and have a surface roughness RMS < 2 nm; and wherein
- the surfaces (21 and 61) of the solid-state disk (2) and the monolithic composite (6) are directly and permanently bonded together.

2. The module (1) according to claim 1, wherein the directly bonded monolithic laser amplification module (1) has a thermal conductivity of >0.1 W/(m K), preferably >1 W/(m K), for solid-state disk temperatures < 500°C caused by laser operation.

3. The module (1) according to claim 1 or 2, wherein the monolithic composite (6) comprising plurality of alternating layers forming the reflective coating (4), wherein layers (41, 42) are made of materials having alternating refractive indexes and wherein the top layer is bonded to the solid-state disk (2).

4. The module (1) according to anyone of the previous claim, wherein the monolithic composite (6) comprises a sacrificial layer (7) on top of the reflective coating (4), wherein the material and the thickness of the sacrificial layer (7) decreases the reflectivity of the coating (4) less than 10 %.

5. The module (1) according to claim 4, wherein the sacrificial layer (7) of the monolithic composite (6) comprises a plurality of layers (71, 72) forming a film stack, wherein at least one sacrificial layer is structured by micro or nano-pattern (711) increasing mechanical and/or thermal properties of the solid-state disk (2).

6. The module (1) according to claim 4 or 5, wherein the sacrificial layer (7) of the monolithic composite (6) comprises a plurality of layers (71, 72) forming a film stack, wherein this film stack is configured to increase the laser-induced damage threshold of the module (1).

7. The module (1) according to anyone of the previous claim, wherein the surface (61) of the monolithic composite (6) directly and permanently bonded to the solid-state disk (2) is curved.

8. The module (1) according to anyone of the previous claim, wherein the surface (21) of the solid-state disk (2) and the surface (61) of the monolithic composite have PV < 70 nm and RMS < 0.8 nm.

9. The module (1) according to anyone of the previous claim, wherein the surface (61) of the module (1) is curved and wherein the curved surface serves for direct and permanent bonding having PV<210 nm and RMS<2 nm; and wherein the curved surface is a part of the total surface of the monolithic composite (6).

10. The module (1) according to anyone of the previous claim, wherein the solid-state disk (2) comprises a doped laser crystal or undoped laser crystal selected from the group consisting of: garnets, vanadates, tungstates, sapphire, chalcogenides or ceramic materials or semiconductor gain material.

11. The module according to anyone of the previous claim, wherein the heat sink (3) is transparent for wavelengths between 200 nm - 10 µm with an attenuation coefficient < 1 cm⁻¹.

12. The module (1) according to anyone of the previous claim, wherein the heat sink (3) is made of diamond, boron nitride, silicon, silicon carbide, ceramic, metal, metal-diamond composite, metal-boron nitride composite or silicon-diamond composite.

13. The module (1) according to anyone of the previous claim, wherein the solid-state disk (2) comprises an anti-reflective coating (22) on the surface opposite to the surface (21) directly and permanently bonded to the monolithic composite (6).

14. The module (1) according to anyone of the previous claim, wherein an edge of the module (1) is roughened and/or bevelled.

15. A method for manufacturing the laser amplification module (1) according to anyone of the previous claim comprises the steps:
- providing a solid-state disk (2), wherein at least one surface (21) thereof has a surface roughness of root mean square RMS <2 nm and a surface flatness of PV< 210 nm;
- providing a heat sink (3), wherein at least one surface (31) thereof has root mean square RMS <2 nm and a surface flatness of PV< 210 nm; and wherein thickness thereof is at least 1 mm;
- coating the heat sink (3) by a reflective coating (4) at least partially reflecting an incident beam (5) in a wavelength range A is 200 nm - 10 µm, thereby forming a monolithic composite (6);
- cleaning the surfaces (21 and 41) of the solid-state disk (2) and the monolithic composite (6);
- activation of the surfaces (21 and 41); and
- aligning and pressing the surfaces (21 and 41) having RMS < 2 nm and a surface flatness of PV< 210 nm of both, the monolithic composite and the heat sink, together to form a direct and permanent bond.

16. The method according to claim 14 further comprising steps:
- providing a sacrificial layer (7);
- further coating of the reflective coating (4) by the sacrificial layer (7), thereby forming a monolithic composite (6);
- processing the sacrificial layer (7) of the monolithic composite (6) either with chemical-mechanical polishing or ion-beam assisted polishing providing surface roughness of RMS < 2 nm and a surface flatness PV < 210 nm reducing the number and size of defects or voids.

## Amended claims

### Amended claims in accordance with Rule 137(2) EPC.

1. A monolithic laser amplification module (1) for a solid-state laser system comprising
- a solid-state disk (2);
- a monolithic composite (6) comprising a heat sink (3) and a reflecting coating (4) configured to at least partially reflect an incident beam (5) propagated in the solid-state disk (2) in a wavelength range λ from 200 nm - 10 µm, wherein the reflecting coating (4) is deposited on surface of the heat sink by a deposition method, wherein the heat sink (3) has:
- transverse thermal conductivity at least 100 W/m*K,
- Young's modulus at least 100 GPa, preferably at least 300 GPa; and
- thickness of the heat sink at least 1 mm, preferably at least 2 mm; and wherein
- the solid-state disk and the monolithic composite have surfaces (61 and 21) having peak to valley flatness < 210 nm and have a surface roughness RMS < 2 nm; and wherein
- the surfaces (21 and 61) of the solid-state disk (2) and the monolithic composite (6) are directly and permanently bonded together.

2. The module (1) according to claim 1, wherein the directly bonded monolithic laser amplification module (1) has a thermal conductivity of >0.1 W/(m K), preferably >1 W/(m K), for solid-state disk temperatures < 500°C caused by laser operation.

3. The module (1) according to claim 1 or 2, wherein the monolithic composite (6) comprising plurality of alternating layers forming the reflective coating (4), wherein layers (41, 42) are made of materials having alternating refractive indexes and wherein the top layer is bonded to the solid-state disk (2).

4. The module (1) according to anyone of the previous claim, wherein the monolithic composite (6) comprises a sacrificial layer (7) on top of the reflective coating (4), wherein the material and the thickness of the sacrificial layer (7) decreases the reflectivity of the coating (4) less than 10 %.

5. The module (1) according to claim 4, wherein the sacrificial layer (7) of the monolithic composite (6) comprises a plurality of layers (71, 72) forming a film stack, wherein at least one sacrificial layer is structured by micro or nano-pattern (711) increasing mechanical and/or thermal properties of the solid-state disk (2).

6. The module (1) according to claim 4 or 5, wherein the sacrificial layer (7) of the monolithic composite (6) comprises a plurality of layers (71, 72) forming a film stack, wherein this film stack is configured to increase the laser-induced damage threshold of the module (1).

7. The module (1) according to anyone of the previous claim, wherein the surface (61) of the monolithic composite (6) directly and permanently bonded to the solid-state disk (2) is curved.

8. The module (1) according to anyone of the previous claim, wherein the surface (21) of the solid-state disk (2) and the surface (61) of the monolithic composite have peak to valley flatness< 70 nm and RMS < 0.8 nm.

9. The module (1) according to anyone of the previous claim, wherein the surface (61) of the module (1) is curved and wherein the curved surface serves for direct and permanent bonding having peak to valley flatness <210 nm and RMS<2 nm; and wherein the curved surface is a part of the total surface of the monolithic composite (6).

10. The module (1) according to anyone of the previous claim, wherein the solid-state disk (2) comprises a doped laser crystal or undoped laser crystal selected from the group consisting of: garnets, vanadates, tungstates, sapphire, chalcogenides or ceramic materials or semiconductor gain material.

11. The module according to anyone of the previous claim, wherein the heat sink (3) is transparent for wavelengths between 200 nm - 10 µm with an attenuation coefficient < 1 cm⁻¹.

12. The module (1) according to anyone of the previous claim, wherein the heat sink (3) is made of diamond, boron nitride, silicon, silicon carbide, ceramic, metal, metal-diamond composite, metal-boron nitride composite or silicon-diamond composite.

13. The module (1) according to anyone of the previous claim, wherein the solid-state disk (2) comprises an anti-reflective coating (22) on the surface opposite to the surface (21) directly and permanently bonded to the monolithic composite (6).

14. The module (1) according to anyone of the previous claim, wherein an edge of the module (1) is roughened and/or bevelled.

15. A method for manufacturing the laser amplification module (1) according to anyone of the previous claim comprises the steps:
- providing a solid-state disk (2), wherein at least one surface (21) thereof has a surface roughness of root mean square RMS <2 nm and a surface flatness of peak to valley flatness < 210 nm;
- providing a heat sink (3), wherein at least one surface (31) thereof has root mean square RMS <2 nm and a surface flatness of peak to valley flatness < 210 nm; and wherein thickness thereof is at least 1 mm;
- coating the heat sink (3) by a reflective coating (4) at least partially reflecting an incident beam (5) in a wavelength range λ is 200 nm - 10 µm, thereby forming a monolithic composite (6);
- cleaning the surfaces (21 and 41) of the solid-state disk (2) and the monolithic composite (6);
- activation of the surfaces (21 and 41); and
- aligning and pressing the surfaces (21 and 41) having RMS < 2 nm and a surface flatness of peak to valley flatness < 210 nm of both, the monolithic composite and the heat sink, together to form a direct and permanent bond.

16. The method according to claim 14 further comprising steps:
- providing a sacrificial layer (7);
- further coating of the reflective coating (4) by the sacrificial layer (7), thereby forming a monolithic composite (6);
- processing the sacrificial layer (7) of the monolithic composite (6) either with chemical-mechanical polishing or ion-beam assisted polishing providing surface roughness of RMS < 2 nm and a surface flatness peak to valley flatness < 210 nm reducing the number and size of defects or voids.
